# EUROPÄISCHE PATENTSCHRIFT

(11) **EP 0 594 171 B1**
(45) Veröffentlichungstag und Bekanntmachung des Hinweises auf die Patenterteilung: **12.03.1997**
(21) Anmeldenummer: 93117079.9
(22) Anmeldetag: 21.10.1993
(51) Int. Cl.: C03C 17/245, C03C 17/00, C23C 16/44, C23C 16/40

(54) **Verfahren und Vorrichtung zum Modifizieren der Oberflächenaktivität eines Silikatglas Substrates**
Process and apparatus for the modification of the surface activity of a silicate glass substrate
Procédé et appareil pour la modification de l'activité en surface d'un substrat en verre silicate

(30) Priorität: 23.10.1992 DE 4235897; 10.11.1992 DE 4237921
(43) Veröffentlichungstag der Anmeldung: 27.04.1994
(73) Patentinhaber: FLACHGLAS AKTIENGESELLSCHAFT, 90762 Fürth (DE)
(72) Erfinder: Tiller, Hans-Jürgen, Prof.Dr., D-07745 Jena (DE); Apfel, Christina, Dipl.-Phys.Ing., D-07745 Jena (DE); Hoyer, Thomas, Dipl.-Chem., D-99448 Tannroda (DE); Drexler, Hubert, D-93051 Regensburg (DE)
(74) Vertreter: Goddar, Heinz J., Dr.

(56) Entgegenhaltungen:
- EP-A- 0 212 691
- EP-A- 0 348 185
- BE-A- 667 584
- GB-A- 2 247 691
- DATABASE WPI Derwent Publications Ltd., London, GB; AN 91-037519 & DD-A-282 179 (UNIV SCHILLER JENA)
- THIN SOLID FILMS Bd. 174, Nr. 1 , Juli 1989 , LAUSANNE CH Seiten 57 - 61 XP84429 KULISCH ET AL 'PLASMA ENHANCED CHEMICAL VAPOUR DEPOSITION OF SILICONDIOXIDE USING TETRAETHOXYSILANE AS SILICON SOURCE'

## Beschreibung

Die Erfindung betrifft ein Verfahren zum Modifizieren der Oberflächenaktivität, wie Hydrophilieren, eines Silikatglassubstrates durch Aufbringen einer siliziumhaltigen Beschichtung unter Verwendung wenigstens einer siliziumorganischen Substanz sowie eine Vorrichtung insbesondere zur Durchführung eines derartigen Verfahren.

Aus der AT-PS 381 693 ist ein Verfahren der vorstehend beschriebenen Art bekannt, bei dem der Oberfläche eines Silikatglassubstrates dadurch hydrophile Eigenschaften verliehen werden, daß auf die Oberfläche des Glassubstrates eine Sulfonato-Organosilanol-Verbindung aufgebracht und anschließend getrocknet wird.

Eine ähnliche Vorgehensweise ist aus der DE-PS 35 11 720 bekannt, wobei dort im Floatverfahren hergestellte Glasscheiben dadurch hydrophiliert werden, daß die Scheiben in mehreren Behandlungsstufen mit flüssigen Medien, insbesondere mit einem alkalischen Phosphat-Glasreiniger und einer phosphorsäurehaltigen Lösung, behandelt werden. Derartige Vorgehensweisen haben einerseits den Nachteil, daß sie, betrachtet man die Modifizierung der Oberflächenaktivität von Floatglasbändern, nur "off-line", also nach dem Zerteilen des Floatglasbandes in einzelne Glasscheiben, angewendet werden können, vorzugsweise im Tauchverfahren, und verhältnismäßig zeitaufwendig sind. Darüber hinaus ist es beispielsweise bei der Anwendung der behandelten Glassubstrate als Objektträger problematisch, daß die hydrophilierende Beschichtung organische Bestandteile aufweist, bei denen eine unerwünschte Wechselwirkung mit den zu untersuchenden Substanzen, z. B. Mikroben, nicht ausgeschlossen werden kann. Auch hat es sich gezeigt, daß die bei den vorstehend beschriebenen Verfahren erreichbare Hydrophilierung für manche Anwendungszwecke, beispielsweise die hydrophilierende Behandlung von für Windschutzscheiben bestimmten Glasscheiben, nicht ausreichend ist.

Gerade bei Floatglas ist eine Modifizierung der Oberflächenaktivität von besonderer Bedeutung, weil insbesondere die mit dem Sn-Bad der Floatglasanlage in Kontakt befindliche Unterseite des Floatglasbandes sehr schlecht benetzbar ist. Dies ist darauf zurückzuführen, daß die untere Glasoberfläche aus dem flüssigen Zinnbad Zinnatome aufnimmt. Insbesondere derartige "badseitige" Flächen von Floatglas lassen sich nur schlecht z. B. für Windschutzscheiben von Kraftfahrzeugen verwenden, da die schlechte Benetzbarkeit zu erheblicher Schlierenbildung führt, ferner ist auch eine Anwendung z. B. für Objektträger, auf die flüssige Proben aufgebracht werden sollen, nicht möglich.

Aus einer Anzahl von Druckschriften ist es andererseits bereits bekannt, Metalle oder dergleichen im sogenannten "Silicoaterverfahren" in haftungsverbessernder Weise zu behandeln. In diesem Zusammenhang ist es aus der DE-OS 40 12 086 bereits bekannt, Metalle für die kathodische Elektrotauchlackierung dadurch vorzubehandeln, daß zunächst durch Flammenpyrolyse einer siliziumorganischen Substanz, wie Tetraethoxysilan, eine SiOₓ-Schicht aufgebracht und im Anschluß hieran die Oberfläche mit einem Silanhaftvermittler auf ebenfalls siliziumorganischer Basis, z. B. im Tauchverfahren, versehen wird. Eine ähnliche Vorgehensweise zeigt die DD-PS 253 259, bei der ein zu beschichtendes Blech zunächst mit einer kohlenstoffhaltigen flammenpyrolytischen SiOₓ-Schicht versehen und anschließend im Tauchverfahren silanisiert wird. Die DE-OS 34 03 894 bezieht sich auf das flammenpyrolytische Beschichten von Dentalprothesenteilen, die im Anschluß an das Aufbringen der als Haftvermittler dienenden siliziumhaltigen Beschichtung mit Dentalkunststoffen verbunden werden. Bei dem vorstehend beschriebenen Silicoaterverfahren ist es erwünscht bzw. erforderlich, daß die SiOₓ-Schicht einen bestimmten Kohlenstoffgehalt aufweist, um die geforderten haftvermittelnden Eigenschaften zu erzielen. Weitere Merkmale des zur Haftverbesserung eingesetzten bekannten Silicoaterverfahrens ergeben sich aus der DD-PS 256 151.

Der Erfindung liegt die Aufgabe zugrunde, ein Verfahren sowie eine Vorrichtung der gattungsgemäßen Art zu schaffen, welche die kostengünstige Modifizierung der Oberflächenaktivität von Floatglas insbesondere das Hydrophilieren von Floatglassubstraten, ermöglichen, wobei die erzielten Oberflächeneigenschaften dauerhaft über einen längeren Zeitraum Bestand haben sollen.

Erfindungsgemäß wird diese Aufgabe in Weiterbildung des gattungsgemäßen Verfahrens dadurch gelöst, daß die siliziumhaltige Beschichtung durch flammenpyrolytische Zersetzung der siliziumorganischen Substanz(en) als SiOₓ-Beschichtung aufgebracht wird.

Dabei kann vorgesehen sein, daß die siliziumhaltige Beschichtung im wesentlichen kohlenstofffrei aufgebracht wird.

Die Erfindung schlägt auch vor, daß bei der Flammenpyrolyse als siliziumorganische Substanz ein Si-Alkoxysilan in eine Mischung von Luft und Brenngas sowie bedarfsweise Sauerstoff eingeleitet wird.

Dabei kann vorgesehen sein, daß als Si-Alkoxysilan Tetramethoxysilan verwendet wird.

Ferner sieht die Erfindung vor, daß ein Brenngas verwendet wird, welches ganz oder teilweise aus Propan, Butan, Leuchtgas und/oder Erdgas besteht.

Dabei kann auch vorgesehen sein, daß als Brenngas Erdgas verwendet wird.

Eine weitere Ausführungsform des Verfahrens nach der Erfindung ist dadurch gekennzeichnet, daß die siliziumorganische Substanz bei der Flammenpyrolyse der Verbrennungsluft in einem Molverhältnis von 10⁻² bis 10⁻⁶ zugesetzt wird.

Es kann auch vorgesehen sein, daß die siliziumorganische Substanz bei der Flammenpyrolyse der Verbrennungsluft in einem Molverhältnis von ca. 10⁻⁴ zugesetzt wird.

Nach der Erfindung kann auch so vorgegangen werden, daß bei der Flammenpyrolyse ein Volumenverhältnis von Brenngas zu Luft von 1 : 3 bis 1 : 80 verwendet wird.

Dabei kann vorgesehen sein, daß bei der Flammenpyrolyse ein Volumenverhältnis von Brenngas zu Luft von ca. 1 : 10 verwendet wird.

Eine weitere Ausführungsform des Verfahrens nach der Erfindung zeichnet sich dadurch aus, daß die SiOₓ-Beschichtung durch mehrere aufeinanderfolgende flammenpyrolytische Behandlungen als aus mindestens zwei Einzelschichten bestehendes Schichtsystem aufgebracht wird.

Es kann auch vorgesehen sein, daß die Glassubstratoberfläche beim Aufbringen der SiOₓ-Beschichtung auf einer Temperatur von 20 bis 600° C gehalten wird.

Ferner schlägt die Erfindung vor, daß die Floatglasoberfläche beim Aufbringen der SiOₓ-Beschichtung auf einer Temperatur von 80 bis 200° C gehalten wird.

Es kann auch vorgesehen sein, daß die siliziumhaltige Beschichtung in einer Dicke von 1 - 100 nm, vorzugsweise 2 - 20 nm, aufgebracht wird.

Dabei kann so vorgegangen werden, daß die badseitige Oberfläche des Floatglasbandes mit der SiOₓ-Beschichtung versehen wird.

Auch kann nach der Erfindung vorgesehen sein, daß die flammenpyrolytische Beschichtung des Floatglasbandes on-line in erzeugungswarmem Zustand erfolgt.

Die erfindungsgemäß vorgeschlagene Vorrichtung zum Modifizieren der Oberflächenaktivität, wie Hydrophilieren, eines Silikatglassubstrates durch Aufbringen einer siliziumhaltigen Beschichtung unter Verwendung wenigstens einer siliziumorganischen Substanz ist dadurch gekennzeichnet, daß in einer dem Floatglasbad nachgeschalteten Beschichtungsstation unterhalb der Bahn des Floatglasbandes im wesentlichen senkrecht zur Fortbewegungsrichtung des Floatglasbandes 3 bis 20 Stabbrenner zur flammenpyrolytischen Zersetzung der siliziumorganischen Substanz(en) angeordnet sind. Als Stabbrenner wird eine linienförmige Anordnung einer Vielzahl von feinen Brennerdüsen bezeichnet, die nur geringe Abstände voneinander aufweisen. Zweck eines solchen Stabbrenners - auch Bandbrenner genannt - ist die Erzeugung eines möglichst gleichmäßigen Flammenbandes entlang der gesamten Brennererstreckung.

Dabei kann vorgesehen sein, daß die Flammenaustrittsöffnungen der Stabbrenner in einem Abstand von 3 bis 50 mm unterhalb der badseitigen Oberfläche des Floatglasbandes angeordnet sind.

Eine weitere Ausführungsform der Erfindung sieht vor, daß die Austrittsöffnungen der Stabbrenner in einem Abstand von 8 bis 12 mm unterhalb der badseitigen Oberfläche des Floatglasbandes angeordnet sind.

Es kann auch vorgesehen sein, daß zumindest ein Teil der Stabbrenner in Fortbewegungsrichtung des Floatglasbandes gleichen gegenseitigen Abstand aufweist.

Nach der Erfindung kann auch vorgesehen sein, daß zumindest ein Teil der Stabbrenner in Fortbewegungsrichtung des Floatglasbandes zunehmenden gegenseitigen Abstand aufweist.

Eine weitere Ausführungsform der Vorrichtung nach der Erfindung ist dadurch gekennzeichnet, daß die Stabbrenner zu Gruppen von jeweils 2 - 5 Stabbrennern zusammengefaßt sind, wobei der gegenseitige Abstand der Stabbrenner innerhalb der jeweiligen Gruppe kleiner ist als der gegenseitige Abstand der jeweiligen Stabbrennergruppen.

Auch kann bei der Vorrichtung nach der Erfindung vorgesehen sein, daß der Auftreffwinkel der aus den Stabbrennern austretenden Brennerflammen bezüglich der Oberfläche des Glassubstrates einstellbar ist.

Die Erfindung schlägt ggf. auch vor, daß der Abstand der Stabbrenner von der Oberfläche des Glassubstrates einstellbar ist.

Auch kann die erfindungsgemäße Vorrichtung dadurch gekennzeichnet sein, daß die einzelnen Stabbrenner jeweils eine Vielzahl quer zur Fortbewegungsrichtung des Floatglasbandes mit gegenseitigem Abstand angeordneter Düsenröhrchen oder -öffnungen aufweisen.

Der Erfindung liegt die überraschende Erkenntnis zugrunde, daß es gelingt, die Oberflächen von Floatglassubstraten, insbesondere auch die badseitigen Oberflächen von Floatglasbändern, dadurch dauerhaft zu modifizieren, insbesondere zu hydrophilieren, daß mittels Flammenpyrolyse eine extrem dünne SiOₓ-Schicht mit einer definierten Oberflächenstruktur und Oberflächenmorphologie aufgebracht wird. Um eine besonders geeignete Schichtbildungsrate zu ermöglichen, ist es dabei zweckmäßig, die siliziumorganische Verbindung in der beanspruchten Weise in optimalem Mol-%-Anteil der Verbrennungsluft zuzumischen. Dies läßt sich entweder durch eine an den Dampfdruck der jeweiligen siliziumorganischen Verbindung angepaßte Temperierung der Dosiereinrichtung bis zum Brenner hin ermöglichen, durch den Einsatz eines ausreichend flüchtigen Alkoxysilans oder durch die Verwendung einer regelbaren, eine Feinstdüse aufweisenden Dosiereinrichtung.

Bei der erfindungsgemäßen Beschichtung des Glassubstrats mittels Flammenpyrolyse bildet sich eine Schicht aus, die im wesentlichen aus Silizium und Sauerstoff besteht. Sie weist eine stark zerklüftete Oberfläche auf, wobei diese Oberfläche wie alle der Luft ausgesetzten Silikatoberflächen vor allem Si-OH-Bindungen aufweist (entstanden aus adsorbiertem Wasserdampf). Die Beschichtung kann damit vereinfacht durch die Summenformel SiOₓ (OH)_{y} charakterisiert werden, wobei der Gesamt-Sauerstoffgehalt x + y größer als 2 ist.

Es hat sich gezeigt, daß für den erfindungsgemäßen Anwendungszweck, also die optimale Hydrophilierung der Glasoberfläche, die flammenpyrolytisch aufgebrachte Beschichtung möglichst kohlenstofffrei sein soll, wobei dies insbesondere durch den Einsatz von Tetramethoxysilan erreicht werden kann. Dies steht ganz im Gegensatz zum bekannten Einsatz des Silicoaterverfahrens zur Haftschichtbildung. Während im übrigen bei letzterem die Brennertemperatur zur Vermeidung einer zu großen Aufheizung der Metallegierung und zwecks Vermeidung einer Oberflächenoxidierung möglichst niedrig gehalten werden muß, zeigt sich bei der Durchführung des erfindungsgemäßen Verfahrens zur Erzielung einer dauerhaften Hydrophilie auch der Einsatz energiereicher Brennergase, wie Methan, als vorteilhaft. Eine Zumischung von Sauerstoff bietet eine weitere Möglichkeit, sowohl die Flammentemperatur zu erhöhen als auch den Kohlenstoffanteil in der Beschichtung zu erniedrigen.

Eine Besonderheit der erfindungsgemäß hergestellten Beschichtung besteht in einer dicken- und temperaturabhängigen Morphologie. Diese hat ihre Ursache in einer sich mit diesen Parametern ändernden Struktur und OH-Gruppendichte der vorzugsweise vorgesehenen Einzelschichten des Beschichtungssystems. Für ein optimales Benetzungsverhalten hat es sich als zweckmäßig erwiesen, die hydrophilierende SiOₓ-Beschichtung in mehreren aufeinanderfolgenden Prozeßschritten aufzutragen. Als optimal hat sich hierbei ein Auftrag in 3 bis 20, vorzugsweise in 6 bis 14, Beschichtungsschritten erwiesen.

Für die strukturellen und damit hydrophilierenden Eigenschaften der Schichten spielt die Temperatur der Oberfläche, die sich als Kombination der Glastemperatur und der Aufheizung durch die Flamme ergibt, ebenfalls eine wichtige Rolle. Es hat sich gezeigt, daß insbesondere Temperaturen im Bereich von 80 bis 200° C zu besonders günstigen Schichteigenschaften führen. Die zeitliche Aufeinanderfolge der einzelnen Beschichtungsschritte liegt dabei im Sekundenbereich.

Weitere Merkmale und Vorteile der Erfindung ergeben sich aus der nachfolgenden Beschreibung, in der ein Ausführungsbeispiel anhand der schematischen Zeichnung im einzelnen erläutert ist. Dabei zeigt:
- Fig. 1: ein Ausführungsbeispiel einer Vorrichtung nach der Erfindung in perspektivischer Seitenansicht von schräg oben;
- Fig. 2: einen Schnitt entlang der Linie II - II von Fig. 1;
- Fig. 3: ein Ausführungsbeispiel einer Vorrichtung zum Mischen des erfindungsgemäß ggf. verwendbaren Tetramethoxysilans im Schnitt; und
- Fig. 4: eine Diagrammdarstellung des mittels des erfindungsgemäßen Verfahrens bei einem Ausführungsbeispiel erzielbaren lierungseffektes.

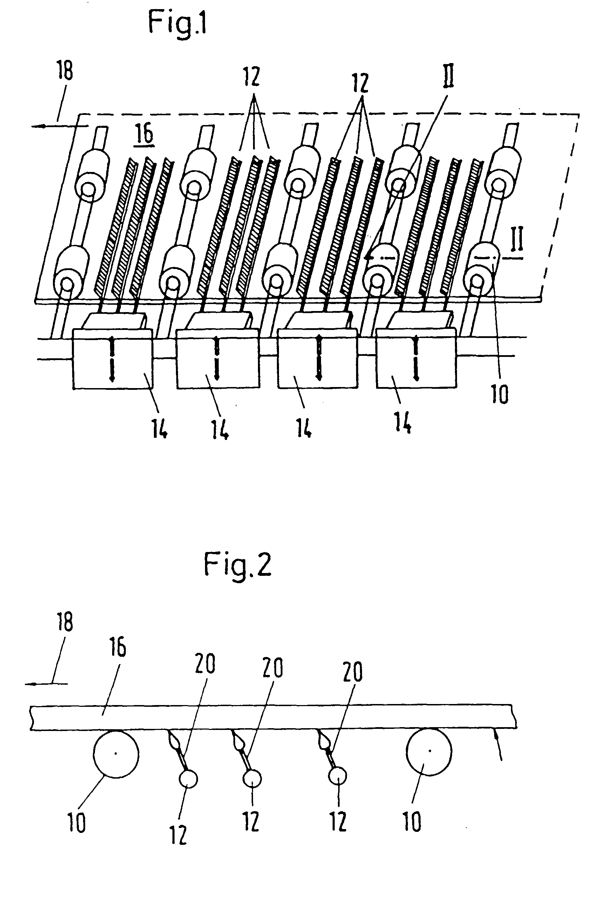

Wie Fig. 1 erkennen läßt, sind dort zwischen einer Anzahl aufeinanderfolgender gummibeschichteter Stützrollen 10, die an eine an Fig. 1 rechts anschließende, nicht gezeigte Floatglaswanne anschließen, eine Anzahl von Stabbrennern 12 angeordnet, die durch Brennerhalterungen 14 höhen- und winkelverstellbar abgestützt sind. Auf den Stützrollen 10 liegt ein erzeugungswarmes Floatglasband 16 mit einer Oberflächentemperatur von etwa 160° C auf, welches sich in Richtung des Pfeiles 18 mit einer Geschwindigkeit, durch die Floatglasherstellung bedingt, von im allgemeinen 5 - 25 m/Min., im gezeigten Ausführungsbeispiel 14 m/Min., in Fig. 1 nach links bewegt.

Die Höhe der Stabbrenner 14 läßt sich derart einstellen, daß der Abstand der Stabbrenner 12 zur Unterseite des Floatglasbandes 16 3 bis 50 mm, vorzugsweise 8 bis 12 mm, beträgt. Im konkreten Ausführungsbeispiel beträgt der Brennerabstand zur Unterseite des Floatglasbandes 8 mm.

Wie Fig. 2 erkennen läßt, läßt sich nicht nur der Abstand der Stabbrenner 10 zur Unterfläche des Floatglasbandes 16 mittels der Brennerhalterungen 14 einstellen, sondern auch der Winkel, mit dem die aus zahlreichen Düsenröhrchen 20, welche über die Stabbrennerlänge quer zum Floatglasband 16 in großer Zahl mit gleichem geringem Abstand verteilt angeordnet sind, austretenden Flammen auf die Unterfläche des Floatglasbandes 16 auftreffen.

Mittels des vorstehend beschriebenen Ausführungsbeispieles der Vorrichtung nach der Erfindung wurde nach dem erfindungsgemäßen Verfahren bei dem hier beschriebenen Ausführungsbeispiel wie folgt gearbeitet:

Das Floatglasband 16, mit einer Dicke von 3 mm, wurde, wie bereits dargelegt, mit einer Geschwindigkeit von 14 m/Min. auf der Badseite (Unterseite) durch Flammenpyrolyse mit einer kohlenstofffreien SiOₓ-Schicht versehen. Der Brennerabstand zum Glas betrug dabei 8 mm. Die beschichtete Breite des Floatglasbandes betrug etwa 60 cm. Für die in vier Brennerbatterien zu je drei Brennern angeordneten Stabbrenner 12 wurden pro Stabbrenner die folgenden Gaseinstellungen verwendet:
- Silan-Luft-Gemisch:: 2000 l/h
- Erdgas:: 400 l/h

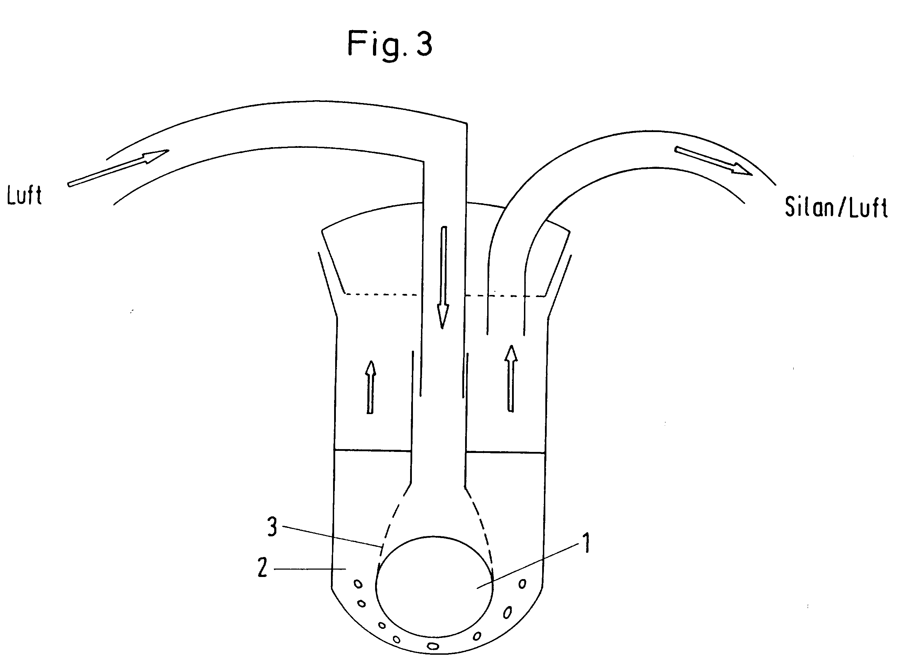

Das Mischen des verwendeten Tetramethoxysilans mit der Luft wurde in der in Fig. 3 dargestellten Vorrichtung durchgeführt. Dabei durchströmt der Luftstrom einen Schwimmer 1, der in das Silan 2 eintaucht und durch dessen Austrittsöffnung 3 die Luft das Silan als Bläschen passiert, wobei eine Beladung der Luft mit gesättigter Silanatmosphäre erfolgt. Der Anteil des Silans an dem Silan/Luft-Gemisch läßt sich durch Variation der Silantemperatur und damit des Silandampfdruckes steuern.

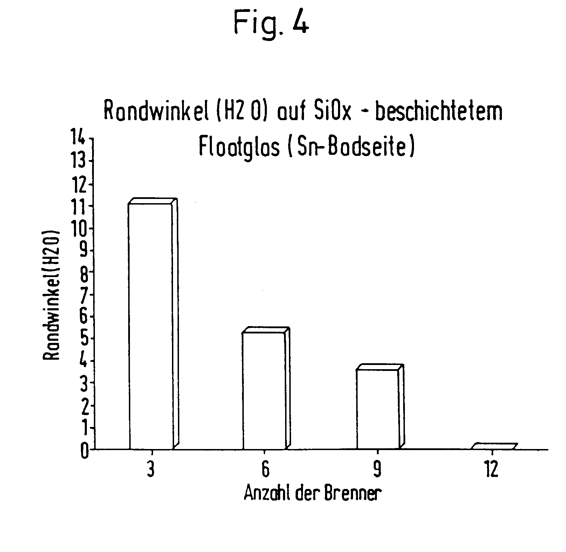

Aus Fig. 4 läßt sich erkennen, daß die Benetzbarkeit der Floatglasoberfläche nach der flammenpyrolytischen Beschichtung mit steigender Anzahl verwendeter Brennerbatterien stark ansteigt. So ergibt sich bereits nach dem Passieren einer ersten Batterie aus 3 Stabbrennern eine Verringerung des bei nicht-behandeltem Floatglas zu beobachtenden Randwinkels (H₂O) von 26° auf ca. 11°, der dann nach dem Passieren einer weiteren Batterie von 3 Stabbrennern, also insgesamt nach dem Passieren von 6 Stabbrennern, auf weniger als die Hälfte des vorstehend genannten Wertes sinkt.

Das nach dem vorstehend beschriebenen Ausführungsbeispiel erhaltene Floatglas läßt sich hervorragend für Anwendungszwecke einsetzen, in denen eine hohe Benetzbarkeit der Glasfläche wünschenswert ist, so beispielsweise für Windschutzscheiben von Kraftfahrzeugen, da hierdurch der gefürchtete Schliereneffekt wirksam verringert werden kann. Bei entsprechend dünnerem Floatglas lassen sich nach dem erfindungsgemäßen Verfahren natürlich auch bevorzugt, wie bereits dargelegt, Objektträger oder dergleichen herstellen.

### BEZUGSZEICHENLISTE

- 1: Schwimmer
- 2: Silan
- 3: Austrittsöffnung
- 10: Stützrolle
- 12: Stabbrenner
- 14: Brennerhalterung
- 16: Floatglasband
- 18: Richtungspfeil (Floatglasbewegung)
- 20: Düsenröhrchen

## Patentansprüche

1. Verfahren zum Modifizieren der Oberflächenaktivität, wie Hydrophilieren, eines Silikatglassubstrates durch Aufbringen einer siliziumhaltigen Beschichtung unter Verwendung wenigstens einer siliziumorganischen Substanz, dadurch gekennzeichnet, daß als Glassubstrat ein Floatglasband eingesetzt und die siliziumhaltige Beschichtung durch flammenpyrolytische Zersetzung der siliciumorganischen Substanz(en) als SiOₓ-Beschichtung aufgebracht wird.

2. Verfahren nach Anspruch 1, dadurch gekennzeichnet, daß die siliziumhaltige Beschichtung im wesentlichen kohlenstofffrei aufgebracht wird.

3. Verfahren nach Anspruch 1 oder 2, dadurch gekennzeichnet, daß bei der Flammenpyrolyse als siliziumorganische Substanz ein Si-Alkoxysilan, beispielsweise Tetramethoxysilan in eine Mischung von Luft und Brenngas sowie bedarfsweise Sauerstoff eingeleitet wird.

4. Verfahren nach Anspruch 3, dadurch gekennzeichnet, daß ein Brenngas verwendet wird, welches ganz oder teilweise aus Propan, Butan, Leuchtgas und/oder Erdgas besteht.

5. Verfahren nach einem der Ansprüche 1 bis 4, dadurch gekennzeichnet, daß die siliziumorganische Substanz bei der Flammenpyrolyse der Verbrennungsluft in einem Molverhältnis von 10⁻² bis 10⁻⁶ zugesetzt wird.

6. Verfahren nach einem der Ansprüche 3 bis 5, dadurch gekennzeichnet, daß bei der Flammenpyrolyse ein Volumenverhältnis von Brenngas zu Luft von 1 : 3 bis 1 : 80 verwendet wird.

7. Verfahren nach einem der vorangehenden Ansprüche, dadurch gekennzeichnet, daß die SiOₓ-Beschichtung durch mehrere aufeinanderfolgende flammenpyrolytische Behandlungen als aus mindestens zwei Einzelschichten bestehendes Schichtsystem aufgebracht wird.

8. Verfahren nach einem der vorangehenden Ansprüche, dadurch gekennzeichnet, daß die Glassubstratoberfläche beim Aufbringen der SiOₓ-Beschichtung auf einer Temperatur von 20 bis 600° C, vorzugsweise 80 bis 200° C gehalten wird.

9. Verfahren nach einem der vorangehenden Ansprüche, dadurch gekennzeichnet, daß die siliziumhaltige Beschichtung in einer Dicke von 1 - 100 nm, vorzugsweise 2 - 20 nm, aufgebracht wird.

10. Verfahren nach einem der vorangehenden Ansprüche, dadurch gekennzeichnet, daß die badseitige Oberfläche des Floatglasbandes mit der SiOₓ- Beschichtung versehen wird.

11. Verfahren nach einem der vorangehenden Ansprüche, dadurch gekennzeichnet, daß die flammenpyrolytische Beschichtung des Floatglasbandes on-line in erzeugungswarmem Zustand erfolgt.

12. Vorrichtung zum Modifizieren der Oberflächenaktivität, wie Hydrophilieren, eines Silikatglassubstrates durch Aufbringen einer siliziumhaltigen Schicht unter Verwendung einer Si-organischen Substanz, zur Durchführung des Verfahrens nach einem der vorangehenden Ansprüche, dadurch gekennzeichnet, daß in einer dem Floatglasbad nachgeschalteten Beschichtungsstation unterhalb der Bahn des Floatglasbandes (16) im wesentlichen senkrecht zur Fortbewegungsrichtung (18) des Floatglasbandes (16) 3 bis 20 Stabbrenner (12) zur flammenpyrolytischen Zersetzung der siliziumorganischen Substanz(en) angeordnet sind.

13. Vorrichtung nach Anspruch 12, dadurch gekennzeichnet, daß die Flammenaustrittsöffnungen der Stabbrenner (12) in einem Abstand von 3 bis 50 mm unterhalb der badseitigen Oberfläche des Floatglasbandes (16) angeordnet sind.

14. Vorrichtung nach Anspruch 12 oder 13, dadurch gekennzeichnet, daß zumindest ein Teil der Stabbrenner (12) in Fortbewegungsrichtung (18) des Floatglasbandes (16) gleichen gegenseitigen Abstand aufweist.

15. Vorrichtung nach einem der Ansprüche 12 bis 14, dadurch gekennzeichnet, daß zumindest ein Teil der Stabbrenner (12) in Fortbewegungsrichtung (18) des Floatglasbandes (16) zunehmenden gegenseitigen Abstand aufweist.

16. Vorrichtung nach einem der Ansprüche 12 bis 15, dadurch gekennzeichnet, daß die Stabbrenner (12) zu Gruppen von jeweils 2 - 5 Stabbrennern zusammengefaßt sind, wobei der gegenseitige Abstand der Stabbrenner (12) innerhalb der jeweiligen Gruppe kleiner ist als der gegenseitige Abstand der jeweiligen Stabbrennergruppen.

17. Vorrichtung nach einem der Ansprüche 12 bis 16, dadurch gekennzeichnet, daß der Auftreffwinkel der aus den Stabbrennern (12) austretenden Brennerflammen bezüglich der Oberfläche des Floatglasbandes (16) einstellbar ist.

18. Vorrichtung nach einem der Ansprüche 12 bis 17, dadurch gekennzeichnet, daß der Abstand der Stabbrenner (12) von der Oberfläche des Floatglasbandes (16) einstellbar ist.

19. Vorrichtung nach einem der Ansprüche 12 bis 18, dadurch gekennzeichnet, daß die einzelnen Stabbrenner (12) jeweils eine Vielzahl quer zur Fortbewegungsrichtung (18) des Floatglasbandes (16) mit geringem gegenseitigen Abstand angeordneter Düsenröhrchen (20) oder -öffnungen aufweisen.

## Claims

1. A method of modifying the surface activity, such as hydrophilisation, of a silicate glass substrate by the application of a siilicon-containing coating using at least one organo-silicon substance, characterised in that the glass substrate used is a float glass strip and the silicon-containing coating is applied as an SiOₓ coating by flame-pyrolysis decomposition of the organo-silicon substance or substances.

2. A method according to claim 1, characterised in that the silicon-containing coating is applied in substantially carbon-free form.

3. A method according to claim 1 or 2, characterised in that the organo-silicon substance used in the flame pyrolysis is an Si alkoxysilane, for example tetramethoxysilane, which is introduced into a mixture of air and combustible gas and, as required, oxygen.

4. A method according to claim 3, characterised in that a combustible gas consisting completely or partially of propane, butane, coal gas and/or natural gas is used.

5. A method according to any one of claims 1 to 4, characterised in that during the flame pyrolysis the organo-silicon substance is added to the air for combustion in a molar ratio of 10⁻² to 10⁻⁶.

6. A method according to any one of claims 1 to 5, characterised in that the ratio of combustible gas to air by volume during the flame pyrolysis is from 1 : 3 to 1 : 80.

7. A method according to any one of the preceding claims, characterised in that the SiOₓ coating is applied by a plurality of consecutive flame-pyrolysis treatments to give a layer system consisting of at least two individual layers.

8. A method according to any one of the preceding claims, characterised in that during the application of the SiOₓ coating the glass substrate surface is kept at a temperature of from 20 to 600°C, preferably 80 to 200°C.

9. A method according to any one of the preceding claims, characterised in that the silicon-containing coating is applied in a thickness of 1 to 100 nm, preferably 2 - 20 nm.

10. A method according to any one of the preceding claims, characterised in that the float glass strip surface on the bath side is provided with the SiOₓ coating.

11. A method according to any one of the preceding claims, characterised in that the flame-pyrolysis coating of the float glass strip is effected on line in the production-temperature state.

12. Apparatus for modifying the surface activity, such as hydrophilisation, of a silicate glass substrate by the application of a silicon-containing coating using an organo-silicon substance, for performing the method according to any one of the preceding claims, characterised in that 3 to 20 bar burners (12) for flame-pyrolysis decomposition of organo-silicon substance or substances are disposed in a coating station downstream of the float glass bath and beneath the path of the float glass strip (16) and substantially perpendicularly to the direction of advance (18) of the float glass strip (16).

13. Apparatus according to claim 12, characterised in that the flame exit openings of the bar burners (12) are disposed at a distance of 3 to 50 mm beneath the surface of the float glass strip (16) on the bath side.

14. Apparatus according to claim 12 or 13, characterised in that at least some of the bar burners (12) are spaced equal distances apart in the direction of advance (18) of the float glass strip (16).

15. Apparatus according to any one of claims 12 to 14, characterised in that at least some of the bar burners (12) are spaced increasing distances apart in the direction of advance (18) of the float glass strip (16).

16. Apparatus according to any one of claims 12 to 15, characterised in that the bar burners (12) are combined into groups each comprising 2 to 5 bar burners, the distance between the bar burners (12) within each group being less than the distance between the respective bar burner groups.

17. Apparatus according to any one of claims 12 to 16, characterised in that the angle of incidence of the burner flames leaving the bar burners (12) is adjustable with respect to the surface of the float glass strip (16).

18. Apparatus according to any one of claims 12 to 17, characterised in that the distance between the bar burners (12) and the surface of the float glass strip (16) is adjustable.

19. Apparatus according to any one of claims 12 to 18, characterised in that the individual bar burners (12) each comprise a plurality of jets (20) or jet apertures disposed transversely relatively to the direction of advance (18) of the float glass strip (16) with close mutual spacing.

## Revendications

1. Procédé pour modifier l'activité de surface d'un substrat en verre au silicate, comme pour le rendre hydrophile, par application d'un revêtement siliceux en utilisant au moins une substance organosilicique, caractérisé en ce que le substrat en verre mis en oeuvre est un ruban de verre flotté et le revêtement siliceux est appliqué sous la forme d'un revêtement de SiOₓ par décomposition pyrolytique à la flamme de la (des) substance(s) organosilicique(s).

2. Procédé selon la revendication 1, caractérisé en ce que le revêtement siliceux appliqué est pour l'essentiel exempt de carbone.

3. Procédé selon la revendication 1 ou 2, caractérisé en ce que, lors de la pyrolyse à la flamme, un si-alcoxysilane, par exemple du tétraméthoxysilane, est introduit comme substance organosilicique dans un mélange d'air et de gaz combustible ainsi que, si nécessaire, d'oxygène.

4. Procédé selon la revendication 3, caractérisé en ce qu'il fait appel à un gaz combustible constitué en tout ou en partie de propane, de butane, de gaz d'éclairage et/ou de gaz naturel.

5. Procédé selon l'une des revendications 1 à 4, caractérisé en ce que, lors de la pyrolyse à la flamme, la substance organosilicique est ajoutée à l'air de combustion dans un rapport molaire de 10⁻² à 10⁻⁶.

6. Procédé selon l'une des revendications 3 à 5, caractérisé en ce que, lors de la pyrolyse à la flamme, le rapport en volume adopté entre le gaz combustible et l'air est compris entre 1 : 3 et 1 : 80.

7. Procédé selon l'une des revendications précédentes, caractérisé en ce que le revêtement de SiOₓ est appliqué, sous la forme d'un système stratifié constitué d'au moins deux couches distinctes, par plusieurs traitements successifs par pyrolyse à la flamme.

8. Procédé selon l'une des revendications précédentes, caractérisé en ce que, lors de l'application du revêtement de SiOₓ, la surface du substrat en verre est maintenue à une température de 20 à 600 °C, de préférence de 80 à 200 °C.

9. Procédé selon l'une des revendications précédentes, caractérisé en ce que le revêtement siliceux est appliqué selon une épaisseur de 1 à 100 nm, de préférence de 2 à 20 nm.

10. Procédé selon l'une des revendications précédentes, caractérisé en ce que la surface côté bain du ruban de verre flotté est pourvue du revêtement de SiOₓ.

11. Procédé selon l'une des revendications précédentes, caractérisé en ce que le revêtement du ruban de verre flotté par pyrolyse à la flamme s'effectue en continu à la température de fabrication.

12. Dispositif pour modifier l'activité de surface d'un substrat en verre au silicate, comme pour le rendre hydrophile, par application d'une couche siliceuse en utilisant une substance organosilicique dans le but de réaliser le procédé selon l'une des revendications précédentes, caractérisé en ce que, dans une station de revêtement située en aval du bain de verre flotté, de 3 à 20 brûleurs tubulaires (12) sont disposés sous le trajet du ruban de verre flotté (16), sensiblement perpendiculairement au sens de défilement (18) du ruban de verre flotté (16), pour décomposer la (les) substance(s) organosilicique(s) par pyrolyse à la flamme.

13. Dispositif selon la revendication 12, caractérisé en ce que les orifices de sortie des flammes des brûleurs tubulaires (12) se trouvent à une distance de 3 à 50 mm au-dessous de la surface côté bain du ruban de verre flotté (16).

14. Dispositif selon la revendication 12 ou 13, caractérisé en ce qu'au moins une partie des brûleurs tubulaires (12) présente un écartement mutuel égal dans le sens de défilement (18) du ruban de verre flotté (16).

15. Dispositif selon l'une des revendications 12 à 14, caractérisé en ce qu'au moins une partie des brûleurs tubulaires (12) présente un écartement mutuel croissant dans le sens de défilement (18) du ruban de verre flotté (16).

16. Dispositif selon l'une des revendications 12 à 15, caractérisé en ce que les brûleurs tubulaires (12) sont rassemblés par groupes de 2 à 5 brûleurs tubulaires, l'écartement mutuel des brûleurs tubulaires (12) au sein d'un même groupe étant inférieur à l'écartement mutuel des différents groupes de brûleurs tubulaires.

17. Dispositif selon l'une des revendications 12 à 16, caractérisé en ce que l'angle d'incidence des flammes sortant des brûleurs tubulaires (12) par rapport à la surface du ruban de verre flotté (16) est réglable.

18. Dispositif selon l'une des revendications 12 à 17, caractérisé en ce que la distance entre les brûleurs tubulaires (12) et la surface du ruban de verre flotté (16) est réglable.

19. Dispositif selon l'une des revendications 12 à 18, caractérisé en ce que chacun des brûleurs tubulaires (12) comporte une pluralité de buses tubulaires (20) ou d'orifices disposés avec un faible écartement mutuel transversalement au sens de défilement (18) du ruban de verre flotté (16).
